# EUROPEAN PATENT APPLICATION

(11) **EP 4 440 263 A1**
(43) Date of publication of application: **02.10.2024**
(21) Application number: 24163715.6
(22) Date of filing: 15.03.2024
(51) Int. Cl.: H05K 7/14, H01L 23/40, H05K 7/20

(54) **HOLDING DOWN CONSTRUCTION FOR A PRINTED CIRCUIT BOARD**

(30) Priority: 30.03.2023 GB 202304705
(71) Applicant: Rolls-Royce Deutschland Ltd & Co KG, 15827 Blankenfelde-Mahlow (DE)
(72) Inventor: Hegedüs-Fuchs, Gergely László, 15827 Blankenfelde-Mahlow (DE); FARKAS, Daniel, 15827 Blankenfelde-Mahlow (DE); FODOR, Tamás Attila, 15827 Blankenfelde-Mahlow (DE)

(57) **Abstract**

A holding down construction (100) for a printed circuit board. The holding down construction (100) comprises a grid-like basic structure (1) comprising first ribs (10, 10a) and second ribs (20) arranged in a crossed manner, wherein the first ribs (10, 10a) and the second ribs (20) form intersections (13), and wherein the basic structure (1) has an upper side (11) and a lower side (12). The holding down construction further comprises screwing posts (2) attached to the basic structure (1) and configured to be screwed against a printed circuit board (4) and/or another component, and contact structures (3) attached to the lower side (12) of the basic structure (1) and configured to lie against and exert a force against the printed circuit board (4).

## Description

### Field of the disclosure

The present disclosure relates to a holding down construction for a printed circuit board and a corresponding printed circuit board assembly.

### Background

It is known to press printed circuit board (PCB) based power electronics devices to a heat sink for cooling, whereby the power electronics devices to be cooled are typically designed as surface-mounted devices (SMD) or through-hole technology (THT) devices and located on the underside of the PCB. To compensate for height tolerances, it is further known to press such PCB based power electronics devices against a heat sink through a thermal interface material. As such thermal interface material reduces the cooling performance compared to a direct contact, there is a desire to reduce the thickness of such thermal interface material to the extent possible.

The use of holding down clamps represents an effective means to limit the deformation of a printed circuit board. Preventing bending of the printed circuit board alone already leads to an increase in lifetime and reliability. Further, by limiting the deformation of a printed circuit board through a holding down clamp, the pressure between a power electronics device connected to the printed circuit board and a heat sink can be increased. The higher the pressure between the heat sink and the component to be cooled, the greater the thermal conductivity and thus the cooling effect of the heat sink. The increased pressure further allows to limit the thickness of the thermal interface material and keep such thickness within a predefined tolerance range.

Printed circuit boards with power electronics devices used in electric drives located in aircrafts need to be robust against temperature changes, with temperatures varying between minus 40° C and 150° C. Since a printed circuit board comprises several different materials which are stacked upon each other, the bending of a printed circuit board is unavoidable with temperature change because of different coefficients of thermal expansion of the different materials. The displacement of the printed circuit board can increase the distance between the critical components from the heat sink, setting up high requirements towards the thermal interface material and potentially distorting the board critically.

The present disclosure provides a holding down construction that holds down a printed circuit board over a wide temperature range in a manner that addresses the forementioned issues or at least provides a useful alternative to known holding down constructions for printed circuit boards.

### Summary of the disclosure

According to a first aspect a holding down construction for a printed circuit board is provided. The holding down construction comprises a grid-like basic structure comprising first ribs and second ribs arranged in a crossed manner, wherein the first ribs and the second ribs form intersections, and wherein the basic structure has an upper side and a lower side. The holding down construction further comprises screwing posts attached to the basic structure and configured to be screwed against a printed circuit board and/or another component such as a heat sink, and contact structures attached to the lower side of the basic structure and configured to lie against and exert a force against the printed circuit board.

Aspects of the disclosure are thus based on the idea of providing a holding down construction in the form of a grid-like basic structure to which screwing posts and contact structures are attached (including integrated). The grid-like basic structure is naturally flexible and allows to provide a counterforce against any deformation of the printed circuit board caused by a temperature change or by other reasons in an efficient manner, wherein the counterforce is exerted on the circuit board through the contact structures of the holding down construction which may be formed as pins. Bending away of the printed circuit board from a heat sink can thus be efficiently prevented or reduced. At the same time, the screwing posts allow to connect the holding down construction to the printed circuit board and/or a heat sink, providing sufficient load for the fixation.

A further advantage associated with the present holding down construction lies in that, by using a grid-like basic structure, a lighter holding down construction with less material is provided for compared to a solid holding down construction.

The holding down construction may be formed as one part, wherein the screwing posts and the contact structures are integrated into the holding down construction. The holding down construction may be formed by a non-conductive material such as a polymer, in particular for high-voltage applications. However, at noncritical areas such as at the screwing posts metallic components such as metallic compression limiters may be applied for improved screwing of the holding down construction to a printed circuit board assembly.

It should be noted that the side of the holding down construction facing a printed circuit board is always referred to as the lower side of the holding down construction, regardless of the actual spatial orientation of the holding down construction.

According to an aspect of the disclosure, the holding down construction is formed elastically, wherein, when the printed circuit board bends towards the holding down construction, the first ribs and/or the second ribs are elastically deflected at least along sections, thereby providing a counterforce acting against the bending of the printed circuit board. The counterforce is provided through the contact structures of the holding down construction which are located at the ribs. By having a flexible grid-like structure comprised of ribs, a strong counterforce can be created by deflection of the ribs, wherein the counterforce is typically proportional to the deflection.

According to a further aspect of the disclosure, the holding down construction is elastically deformable by a temperature change, wherein, upon an increase and/or decrease in temperature comparted to an assembly temperature, the first ribs and/or the second ribs increase their pressure towards the printed circuit board at least along sections. The increased pressure on the printed circuit board is provided through the contact structures of the holding down construction. This aspect turns a problem into a solution in that a temperature change, which leads to an undesired deformation of the printed circuit board, at the same time automatically increases the downward force by the holding down construction on the printed circuit board, thereby counteracting the deformation of the printed circuit board.

To increase the pressure towards the printed circuit board upon a temperature change, a plurality of different constructions of the ribs are possible. Generally, the underlying idea lies in that the temperature change leads to a lengthening or shortening of ribs or sections of the ribs which causes the respective sections or ribs to bend towards the printed circuit board, thereby increasing the pressure exerted through the contact structures on the printed circuit board. Specific forms of the ribs or sections of the ribs are required to achieve that a lengthening or shortening translates into an increased downward pressure.

In some embodiments at least one section of the first rib and/or at least one section of the second rib is V-shaped towards the printed circuit board. The V- shape may both be at the lower side and at the upper side of the rib or, alternatively, be at the lower side of the rib only, in which case the upper side of the rib may be flat. The V-shape leads automatically to an increased downward pressure if the section forming the V-shape lengthens due to an increased temperature.

In some embodiments at least one section of the first rib and/or at least one section of the second rib has a curved shape, the curved shaped section being convex towards the printed circuit board. The curved shape may be both at the lower side and at the upper side of the rib or, alternatively, be at the lower side of the rib only, in which case the upper side of the rib may be flat. The curved shape leads automatically to an increased downward pressure if the section forming the curved shape lengthens due to an increased temperature. The form of the curve of the curved shape may be circular.

In some embodiments at least one section of the first rib and/or at least one section of the second rib forms a curved V-shape towards the printed circuit board, the curved V-shaped section comprising two subsections convexly curved towards the printed circuit board. Such form may also be referred to as arch shaped. The curved V-shape leads automatically to an increased downward pressure if the section forming the curved V-shape lengthens due to an increased temperature.

In some embodiments at least one section of the first rib and/or at least one section of the second rib forms a diamond shape, the diamond shaped section comprising an upper V-shaped subsection, a lower V-shaped subsection, and an inner hole between the upper V-shaped subsection and the lower V-shaped subsection. A bending down and increased pressure of the rib section can be reached both when the temperature lowers and when the temperature rises compared to the assembly temperature. More particularly, when the temperature is lower than the assembly temperature, the upper V-shaped section bends downwards and provides an extra downward force, and when the temperature is higher than the assembly temperature, the lower V-shaped section bends downwards and provides an extra downward force.

In some embodiments at least one section of the first rib and/or at least one section of the second rib is formed with a T-shape, the T-shaped section comprising a horizontal subsection extending in the direction of the respective rib and a perpendicular subsection extending towards the printed circuit board. Further, the horizontal subsection is attached at its longitudinal ends to a bimaterial which consists of two materials joined together and having a different coefficient of thermal expansion. For example, the bimaterial is a bimetal. Such bimaterial converts a temperature change into a mechanical displacement as the different coefficient of thermal expansion cause the bimaterial to bend, wherein the bending is transferred on the horizontal subsection of the T-shaped section such that an additional downward force of the perpendicular subsection is created.

In such embodiments by choosing if the inner material or the outer material of the bimaterial has a higher coefficient of thermal expansion, an increased downward pressure may be created either when the actual temperature is below the assembly temperature or when the actual temperature is above the assembly temperature.

According to some embodiments the at least one section of the first rib or the at least one section of the second rib extends between two of the screwing posts or between two of the intersections. Naturally, an elastic, bendable section needs to be bounded at its ends by stiffer elements between which the bending takes place. Such stiffer elements may be the screwing posts at which the holding down construction is fixed against a printed circuit board and heat sink. Alternatively, such stiffer elements may be formed by other areas of the holding down construction, such as the intersections of the first ribs and second ribs which comprise an increased rigidity.

In some embodiments the at least one section of the first rib or the at least one section of the second rib forms or is connected at its point closest to the printed circuit board to one of the contact structures configured to lie against and exert a force against the printed circuit board. This ensures that the increased downward pressure is directly transferred onto the printed circuit board, thereby preventing or reducing bending of the printed circuit board towards the holding down construction.

It may be provided that the holding down construction is configured to be mounted on the printed circuit board at an assembly temperature under a preload that provides a force acting on the printed circuit board even when the printed circuit board is not bending towards the holding down construction. Providing a preload ensures that even at assembly temperature the printed circuit board and electric modules attached to the underside of the printed circuit board are pressed against a heat sink for efficient heat transfer.

In some embodiments the screwing posts are attached to and arranged spaced to each other along the first ribs. The screwing posts and the first ribs may be formed of a non-conductive material. However, metal components such as compression limiters may be added to the screwing posts. The screwing posts may be at positions along the first ribs which are located in the middle between neighboring intersections of the first ribs and the second ribs.

Further, the contact structures may be arranged along the second ribs. For example, the contact structures may be located between intersections of the first ribs and the second ribs. Further, at least one, in particular each, contact structure may be arranged at a distance from an adjacent screwing post. The distance may be greater than a diameter of the screwing post, in particular greater than twice the diameter of the screwing post. The contact structure may be arranged on a first or second rib, in a center portion between two screwing posts. The center portion may be defined as a portion of a rib covering a percentage of e.g. 50 % (preferably 20 %, more preferably 10 %) of a distance between two adjacent screwing posts, the portion being arranged symmetrically between these two screwing posts.

In some embodiments the contact structures which are configured to lie against and exert a force against the printed circuit board may comprise at least one pushing pin configured to punctually assert a pressure against the printed circuit board. Accordingly, the ribs assert a force on the printed circuit board at individual points or small areas which allows to assert a high-pressure at these points against the printed circuit board.

The first ribs and the second ribs may run perpendicularly with respect to each other. However, the first ribs and the second ribs may alternatively be angled with respect to each other under an angle different than 90 degrees.

The first ribs, which essentially run parallel to each other, are not necessarily completely identical. There may be some ribs formed differently than other ribs. For example, at least one or most of the ribs may run straight. One or several other ribs may have a different form from a straight line, and, e.g., may comprise curved sections. In general, the form of the ribs may be adapted to run around electric components located on the printed circuit board.

The second ribs may also run parallel to each other and may also do not need to be completely identical. However, in some embodiments, all second ribs run straight.

The holding down construction may be designed as a 3D printed part. However, other forms of manufacture such as casting or injection molding are possible as well. Also, the holding down construction may consist of several parts assembled together.

In a second aspect a printed circuit board assembly is provided that comprises:
a printed circuit board having an upper side and a lower side;
electric modules having an upper side and a lower side;
a heat sink; and
a holding down construction for the printed circuit board;
wherein the electric modules are connected at their upper sides to the lower side of the printed circuit board,
the electric modules are thermally coupled at their lower sides to the heat sink, and
the holding down construction is in accordance with the first aspect and arranged on the upper side of the printed circuit board.

In embodiments, the electric modules each comprise a power semiconductor element. The electric contacts of the electric modules are located at the upper side and electrically connected to respective electric contacts at the lower side of the printed circuit board. For example, each electric module comprises three electric contacts in the form of solder pads at the upper side which provide for a gate voltage, a drain voltage and a source voltage for the power semiconductor element. At the lower side, the electric module may form a thermal interface which is electrically insulated from the power semiconductor element. To this end, one or several ceramic layers may be included in the electric module. The thermal interface of the electric module may be thermally coupled to a heat sink. A thermal interface material may be arranged between the thermal interface of the electric module and the heat sink.

The skilled person will appreciate that except where mutually exclusive, a feature or parameter described in relation to any one of the above aspects may be applied to any other aspect. Furthermore, except where mutually exclusive, any feature or parameter described herein may be applied to any aspect and/or combined with any other feature or parameter described herein. According to this disclosure, the term `holding down construction for a printed circuit board' in particular refers to a 'holding down clamp for a printed circuit board', or a 'printed circuit board holder', or a 'printed circuit board support', therefore these terms may be used interchangeably.

### Brief description of the drawings

The disclosure will be explained in more detail on the basis of exemplary embodiments with reference to the accompanying drawings in which:
**Figure 1** is a perspective view on the lower side of an embodiment of a holding down construction which comprises a grid-like basic structure of first and second ribs, screwing posts and pushing pins;
**Figure 2** is a perspective view on the upper side of the holding down construction of Figure 1;
**Figure 3** is a first side view of the holding down construction of Figure 1;
**Figure 4** is a second side view of the holding down construction of Figure 1;
**Figure 5** is top view on a printed circuit board assembly which comprises a printed circuit board and a holding down construction in accordance with Figures 1 to 4;
**Figure 6** is a view along lines C-C of the printed circuit board assembly of Figure 5;
**Figure 7** is an enlarged view of a section of the view of Figure 6;
**Figure 8** shows schematically a section of a rib of a holding down construction, wherein the section is V-shaped;
**Figure 9** shows schematically a section of a rib of a holding down construction, wherein the section is V-shaped with a flat upper side;
**Figure 10** shows schematically a section of a rib of a holding down construction, wherein the section is curved downwards;
**Figure 11** shows schematically a section of a rib of a holding down construction, wherein the section is curved downwards while having a flat upper side;
**Figure 12** shows schematically a section of a rib of a holding down construction, wherein the section is of a curved V-shape;
**Figure 13** shows schematically a section of a rib of a holding down construction, wherein the section has a diamond shape; and
**Figure 14** shows schematically a section of a rib of a holding down construction, wherein the section is attached at its ends to material layers having different coefficients of thermal expansion.

### Detailed description

Aspects and embodiments of the present disclosure will now be discussed with reference to the accompanying figures. Further aspects and embodiments will be apparent to those skilled in the art.

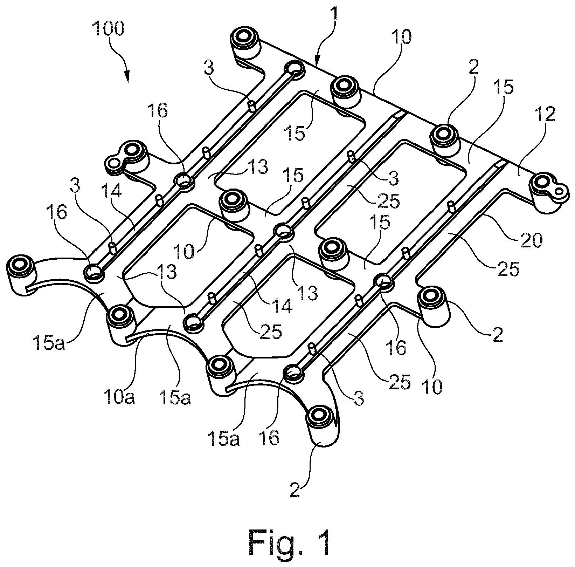

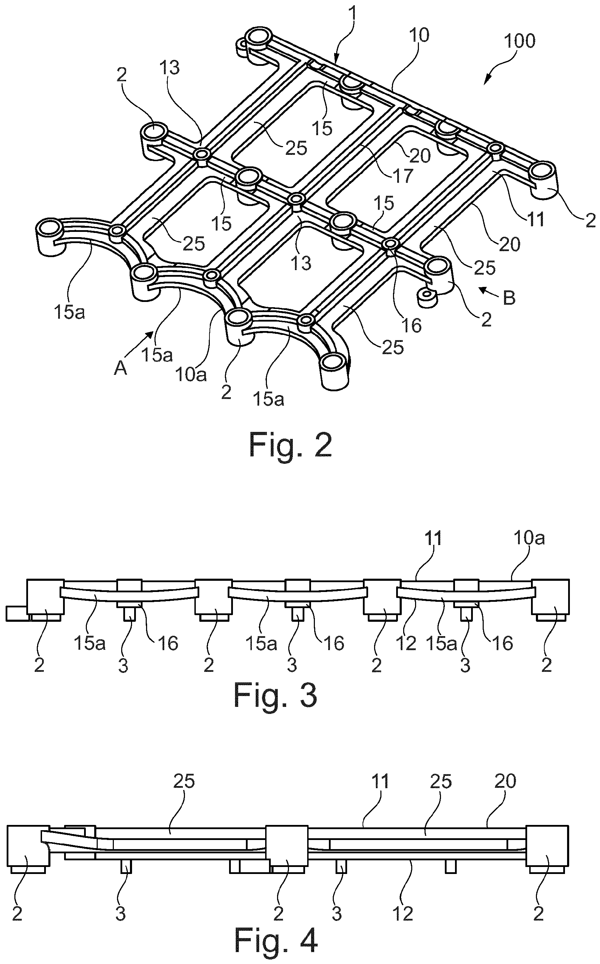

Figures 1 to 4 depict an embodiment of a holding down construction 100, in the following also referred to as holding down clamp, wherein **Figure 1** shows the holding down clamp 100 in a perspective view from the bottom, **Figure 2** shows the holding down clamp 100 in a perspective view from the top, **Figure 3** shows the holding down clamp 100 in a side view along arrow A of Figure 2 and **Figure 4** shows the holding down clamp 100 in a side view along arrow B of Figure 2.

The holding down clamp 100 comprises a grid-like basic structure 1. The grid-like basic structure comprises first ribs 10, 10a and second ribs 20 arranged in a perpendicular manner. Alternatively, the first ribs and the second ribs may be arranged in an angled manner with an intersection angle different than 90 degrees. The first ribs 10, 10a and the second ribs 20 form intersections 13. The basic structure 100 and, accordingly, the first and second ribs 10, 10a, 20 comprise an upper side 11 and a lower side 12.

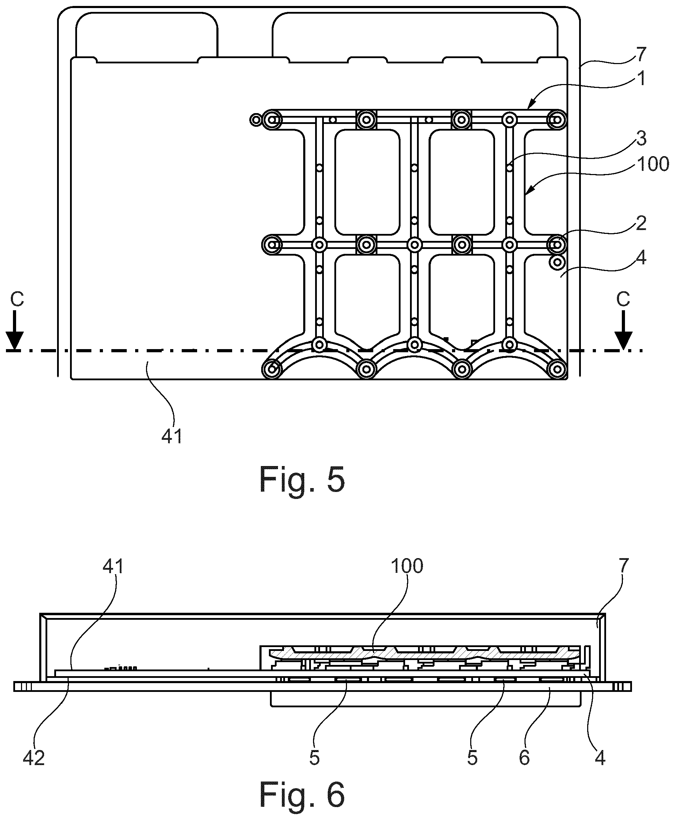

The holding down clamp 100 further comprises screwing posts 2. The screwing posts 2 are configured to be screwed against a printed circuit board and a heat sink, as discussed with respect to Figures 5 to 7. To this end, the screwing posts 2 are configured to receive a screw that allows them to be screwed onto a printed circuit board and heat sink. The screwing posts 2 are attached to the first ribs 10, 10a and arranged at a distance to each other.

The holding down clamp 100 further comprises contact structures 3 which are attached to the lower side 12 of the basic structure 1. The contact structures 3 are configured to lie against a printed circuit board and exert a force on the printed circuit board, as discussed with respect to Figures 5 to 7. They provide for a downward pressure on the printed circuit board that inhibits the printed circuit board to bend towards the holding down clamp 100. In the depicted embodiment, the contact structures are formed as pins 3, also referred as pushing pins 3 as they push against a printed circuit board. The pushing pins 3 are arranged along the second ribs 20 and at a distance to each other. They are provided between two respective intersections 13. In other embodiments, pushing pins 3 may be provided along the first ribs 10, 10a additionally or alternatively.

In the depicted embodiment, but not necessarily, the first ribs comprise two ribs 10 which run straight. The straight ribs 10 are comprised of straight sections 15 that extend between the intersections 13. With the straight ribs 10, the screwing posts 2 are each located in the middle between two intersections 13.

The first ribs further comprise a rib 10a which does not run completely straight, even though still having the same longitudinal extension as the other ribs 10 and still running overall parallel to the other ribs 10. The rib 10a comprises concavely curved sections 15a. The curved sections 15a each extend between two neighboring screwing posts 2.

It is further pointed out that both on the upper side 11 and on the lower side 12 of the second ribs 20 a web 14, 16 is formed that increases the stiffness of the second ribs 20. The pushing pins 3 extend from the web 14 arranged on the lower side 12 of the second ribs 20.

At the intersections 13, holes 16 may be formed in the basic structure 1. The holes are encircled by parts of the mentioned webs 14, 16.

The holding down clamp 100 may be formed by 3D-printing.

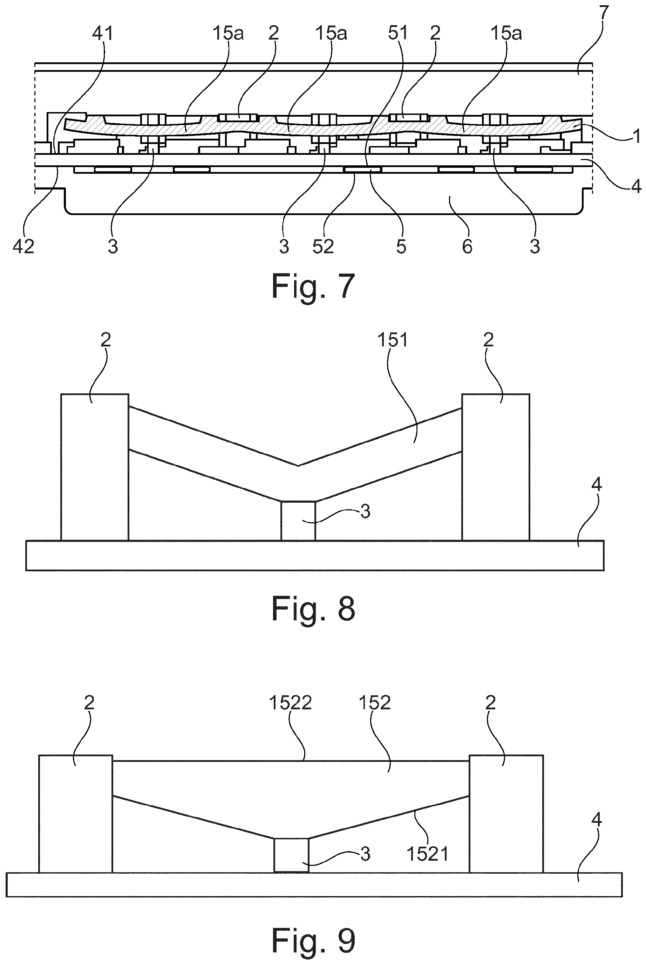

**Figure 5** depicts a printed circuit board assembly which comprises a printed circuit board 4 arranged in a housing structure 7. **Figure 6** shows a partly sectional view along line C-C of Figure 5 and **Figure 7** is an enlarged view of the area of Figure 6 in which the printed circuit board 4 is arranged.

According to Figures 5 to 7, a holding down clamp 100 as depicted in Figures 1 to 4 is attached with its lower side to the upper side 41 of the printed circuit board 4. To this end, screws are screwed into the screwing posts 2 which extend from the screwing posts 2 through the printed circuit board 4 and into a heat sink 6 which is located at the lower side 42 of the printed circuit board 4.

Electric modules 5 which may be power semiconductor modules are attached with their upper side 51 to the lower side 42 of the printed circuit board 4 as shown in Fig. 7. They comprise electric contacts at their upper side 51 which are soldered or otherwise electrically connected to the lower side 42 of the printed circuit board 4. With their lower side 52, the electric modules 5 lie against the heat sink 6. A thermal interface material (not shown) may be placed between the lower side 52 and the heat sink 6 to compensate for height tolerances between the multiple electric modules 5.

As can be seen in Figure 7, the pushing pins 3 of the holding down clamp lie against and push against the upper side 41 of the printed circuit board, thereby preventing or reducing bending of the printed circuit board 4 in the upper direction caused by a temperature change. In particular, if the printed circuit board 4 due to a temperature change bends away from the heat sink 6 and towards the holding down clamp 100, the ribs 10, 10a, 20 including the second ribs 20 to which the pushing pins 3 are attached are elastically deflected, thereby producing a counterforce acting against the bending of the printed circuit board 4. In this respect, it may be provided that the holding down clamp 100 is mounted to the printed circuit board 4 under a preload that provides a force acting on the printed circuit board 4 at an assembly temperature even when the printed circuit board 4 is not bending towards the holding down clamp 100.

Further, in embodiments, a construction of the holding down clamp is provided in which the pressure of the pushing pins 3 onto the circuit board 4 is even increased if the temperature changes compared to an assembly temperature, thereby even more effectively producing a counterforce acting against bending upwards of the printed circuit board 4. This is achieved in embodiments by a downward curving shape of the ribs or sections of the ribs, the downward curving shape leading to an increased downward pressure if the rib lengthens due to a temperature increase.

Figure 7 shows an embodiment in which such effect is achieved in that the curved sections 15a of rib 10a (Figure 1) each have a curved downward shape between two neighboring screwing posts 2. If these curved sections 15a are forced slightly downwards in reaction to a temperature increase, the neighboring pushing pin 3 experience an additional downward force towards the printed circuit board 4, thus additionally pressing against the printed circuit board 4 and compensating for the thermal expansion of the printed circuit board 4.

Several constructions that provide for an increased pressure of a pushing pin 3 onto the printed circuit board 4 in case of a temperature change are discussed with respect to Figures 8 to 14. It is pointed out that these Figures schematically show constructions that extend between two neighboring screwing posts 2. These screwing posts 2 may be the screwing posts of the holding down clamp of Figures 1 to 4. However, the principle of increasing the pressure of the pushing pins 3 in case of a temperature change can be implemented in a large variety of designs of a holding down construction. Generally, the screwing posts 2 may be arranged along the first ribs 10 (as shown in Figures 1 to 4) or may alternatively be arranged along the second ribs 20. Further, instead of by screwing posts, the constructions of Figures 8 to 14 may be limited at its sides by intersections of the first and second ribs such as intersections 13 of Figure 1 or by any other structure of increased stiffness.

**Figure 8** shows an embodiment in which a section 151 of a rib (such as rib 10a of Figures 1 to 4 but alternatively any other rib of a holding down construction) that extends between two screwing posts 2 is V-shaped towards the printed circuit board 4. At its lowest point, a pushing pin 3 is connected to or formed in one part with the V-shaped section 151. The pushing pin 3 lies against and exerts a force against the printed circuit board 4. If the V-shaped section 151 lengthens due to an increase in temperature between the posts 2, the downward force on the pushing pin 3 increases, such that a thermal expansion of section 151 is transformed into an increased holding down force.

Such effect is achieved in a similar manner in the embodiment of **Figure 9** which differs from the embodiment of Figure 8 in that the section 152 that extends between the screwing posts 2 is V-shaped at its lower side 1521 only while having a flat upper side 1522.

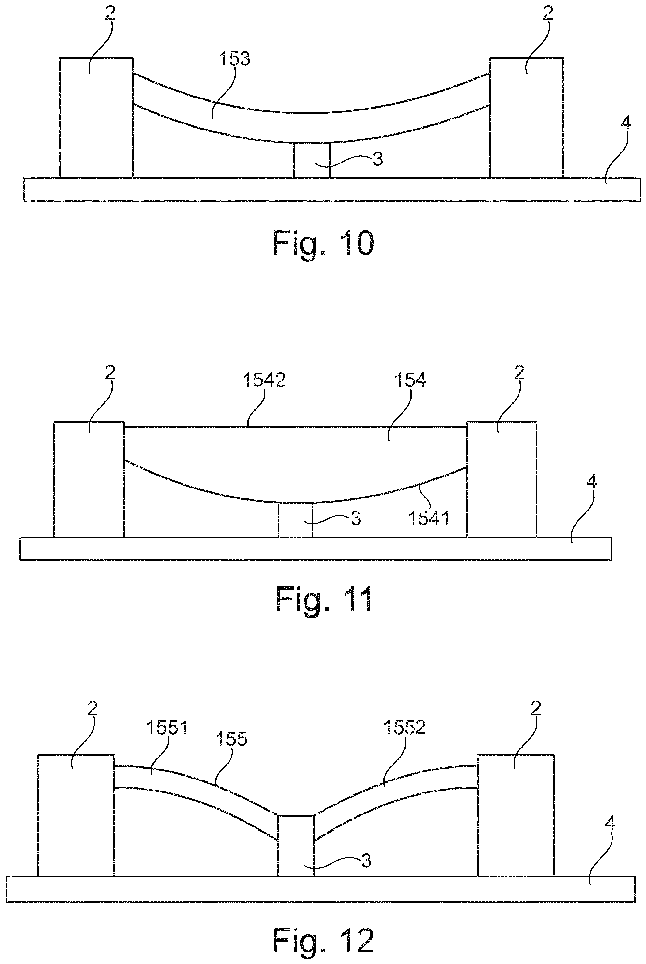

**Figure 10** shows an embodiment in which a curved rib section 153 extends between two screwing posts 2, wherein the curved section is formed convex when viewing on the printed circuit board 4. At its lowest point, a pushing pin 3 is connected to or formed in one part with the curved section 153. The pushing pin 3 lies against and exerts a force against the printed circuit board 4. If the curved section 153 lengthens due to an increase in temperature between the posts 2, the downward force on the pushing pin 3 increases, such that a thermal expansion of section 154 is transformed into an increased holding down force.

Such effect is achieved in a similar manner in the embodiment of **Figure 11** which differs from the embodiment of Figure 10 in that the section 154 that extends between the screwing posts 2 is curved at its lower side 1541 only while having a flat upper side 1542.

**Figure 12** shows an embodiment in which a curved V-shaped section 155 is formed between neighboring screwing posts 2. The curved V-shaped section 155 comprises two subsections 1551, 1552 which are each convexly curved. In the middle of section 155, where the two subsections 1551, 1552 meet, a pushing pin 3 is connected to or formed in one part with the curved section 155. The pushing pin 3 lies against and exerts a force against the printed circuit board 4. If section 155 lengthens due to an increase in temperature between the posts 2, the downward force on the pushing pin 3 increases, such that a thermal expansion of section 155 is transformed into an increased holding down force.

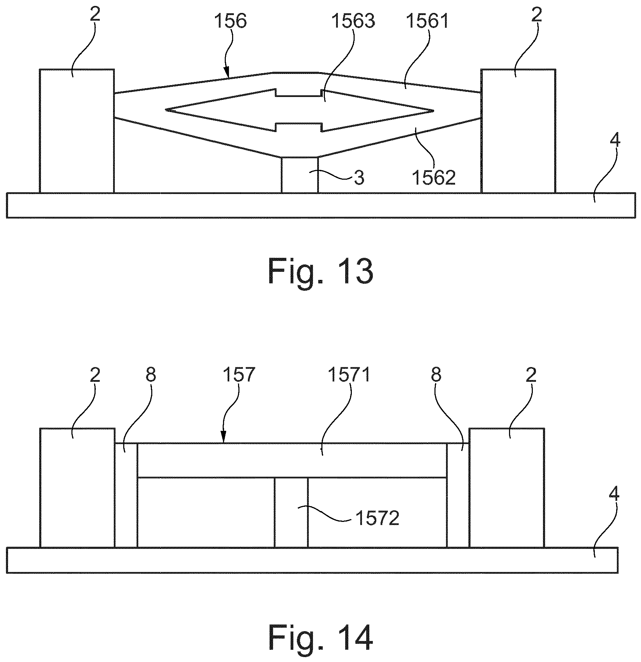

**Figure 13** shows an embodiment in which a section 156 of a rib that extends between two screwing posts 2 comprises a diamond shape in that it comprises an upper V-shaped subsection 1561 and a lower V-shaped subsection 1562, wherein an inner hole 1563 is formed between the two subsections 1561, 1562. At the lowest point of the lower subsection 1562, a pushing pin 3 is connected to or formed in one part with the subsection 1562. The pushing pin 3 lies against and exerts a force against the printed circuit board 4. Such construction is associated with the advantage that both in case of an increase in temperature and in case of a decrease in temperature an additional force is provided on pushing pin 3. More particularly, in case of an increase in temperature compared to an assembly temperature, the lower subsection 1562 bends downward and provides for an extra force on the pushing pin 3. In case of a decrease in temperature compared to an assembly temperature, the upper subsection 5061 bends downwards and provides for an extra force on the pushing pin 3.

**Figure 14** shows an embodiment in which a section 157 of a rib that extends between two screwing posts 2 comprises a T-shape in that it comprises a horizontal subsection 1571 extending in the direction of the rib and a perpendicular subsection 5072 which extends towards the printed circuit board 4 and, in this embodiment, also forms a pushing pin. Between the posts 2 and the longitudinal ends of the horizontal subsection 5071 a further material layer 8 is provided which has a coefficient of thermal expansion different from the coefficient of thermal expansion of the material of the posts 2. Thereby, a bimaterial is formed which causes the horizontal subsection 5071 to bend downwards in case of a temperature change.

It should be understood that the above description is intended for illustrative purposes only, and is not intended to limit the scope of the present disclosure in any way. Also, those skilled in the art will appreciate that other aspects of the disclosure can be obtained from a study of the drawings, the disclosure and the appended claims. All methods described herein can be performed in any suitable order unless otherwise indicated herein or otherwise clearly contradicted by context. Various features of the various embodiments disclosed herein can be combined in different combinations to create new embodiments within the scope of the present disclosure. In particular, the disclosure extends to and includes all combinations and sub-combinations of one or more features described herein. Any ranges given herein include any and all specific values within the range and any and all sub-ranges within the given range.

## Claims

1. A holding down construction for a printed circuit board, the holding down construction (100) comprising:
a grid-like basic structure (1) comprising first ribs (10, 10a) and second ribs (20) arranged in a crossed manner, wherein the first ribs (10, 10a) and the second ribs (20) form intersections (13), and wherein the basic structure (1) has an upper side (11) and a lower side (12);
screwing posts (2) attached to the basic structure (1) and configured to be screwed against a printed circuit board (4) and/or another component; and
contact structures (3) attached to the lower side (12) of the basic structure (1) and configured to lie against and exert a force against the printed circuit board (4).

2. The holding down construction of claim 1, wherein the holding down construction (100) is formed elastically, wherein, when the printed circuit board (4) bends towards the holding down construction, the first ribs (10, 10a) and/or the second ribs (20) are elastically deflected at least along sections, thereby providing a counterforce acting against the bending of the printed circuit board (4).

3. The holding down construction of claim 1 or 2, wherein the holding down construction (100) is elastically deformable by a temperature change, wherein, upon an increase and/or decrease in temperature comparted to an assembly temperature, the first ribs (10, 10a) and/or the second ribs (20) increase their pressure towards the printed circuit board (4) at least along sections (15, 15a, 151-157, 25).

4. The holding down construction of claim 2 or 3, wherein at least one section (151, 152) of the first rib (10, 10a) and/or at least one section (151, 152) of the second rib (20) is V-shaped towards the printed circuit board (4) at least at its lower side.

5. The holding down construction of claim 2 or 3, wherein at least one section (153, 154) of the first rib (10, 10a) and/or at least one section (153, 154) of the second rib (20) has a curved shape at least at its lower side, the curved shaped section (153, 154) being convex towards the printed circuit board.

6. The holding down construction of claim 2 or 3, wherein at least one section (155) of the first rib (10, 10a) and/or at least one section (155) of the second rib (20) forms a curved V-shape towards the printed circuit board, the curved V-shaped section (155) comprising two subsections (1551, 1552) convexly curved towards the printed circuit board (4).

7. The holding down construction of claim 2 or 3, wherein at least one section (156) of the first rib (10, 10a) and/or at least one section (156) of the second rib (20) forms a diamond shape, the diamond shaped section (156) comprising an upper V-shaped subsection (1561), a lower V-shaped subsection (1562) and an inner hole (1563) between the upper V-shaped subsection (1561) and the lower V-shaped subsection (1562).

8. The holding down construction of claim 2 or 3, wherein at least one section (157) of the first rib (10, 10a) and/or at least one section (157) of the second rib (20) is formed with a T-shape, the T-shaped section (157) comprising a horizontal subsection (1571) extending in the direction of the respective rib and a perpendicular subsection (1572) extending towards the printed circuit board (4), wherein the horizontal subsection (1571) is attached at its longitudinal ends at a bimaterial consisting of two materials (8, 2) joined together and having a different coefficient of thermal expansion.

9. The holding down construction of any one of claims 3 to 8, wherein the at least one section (151-157) of the first rib (10, 10a) and/or the at least one section (151-157) of the second rib (20) forms or is connected at its point closest to the printed circuit board (4) to one of the contact structures (3) configured to lie against and exert a force against the printed circuit board (4).

10. The holding down construction of any preceding claim, wherein the holding down construction (100) is configured to be mounted on the printed circuit board (4) at an assembly temperature under a preload that provides a force acting on the printed circuit board (4) even when the printed circuit board (4) is not bending towards the holding down construction (100).

11. The holding down construction of any preceding claim, wherein the screwing posts (2) are attached to and arranged spaced to each other along the first ribs (10, 10a).

12. The holding down construction of claim 11, wherein the screwing posts (2) are at positions along the first ribs (10, 10a) which are located in the middle between neighboring intersections (13) of the first ribs (10, 10a) and the second ribs (20).

13. The holding down construction of any preceding claim, wherein the contact structures (3) are formed as pushing pins configured to punctually assert a pressure against the printed circuit board (4).

14. The holding down construction of any preceding claim, wherein the first ribs (10, 10a) and the second ribs (20) run perpendicularly with respect to each other.

15. A printed circuit board assembly comprising:
a printed circuit board (4) having an upper side (41) and a lower side (42);
electric modules (5) having an upper side (51) and a lower side (52);
a heat sink (6); and
a holding down construction (100) for the printed circuit board (4);
wherein the electric modules (5) are connected at their upper sides (51) to the lower side (42) of the printed circuit board (4),
the electric modules (5) are thermally coupled at their lower sides (52) to the heat sink (6), and
the holding down construction (100) is in accordance with any preceding claim and arranged on the upper side (41) of the printed circuit board (4).
